(19) Europäisches Patentamt / European Patent Office / Office européen des brevets

(11) **EP 3 193 362 A1**

(12) **EUROPEAN PATENT APPLICATION**
published in accordance with Art. 153(4) EPC

(43) Date of publication:
**19.07.2017 Bulletin 2017/29**

(21) Application number: **15840387.3**

(22) Date of filing: **01.09.2015**

(51) Int Cl.:
*H01L 21/822* (2006.01)        *G01R 31/28* (2006.01)
*H01L 21/82* (2006.01)         *H01L 27/04* (2006.01)

(86) International application number:
**PCT/JP2015/004433**

(87) International publication number:
**WO 2016/038848 (17.03.2016 Gazette 2016/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **09.09.2014 JP 2014182836**

(71) Applicant: **NEC Corporation
Tokyo 108-8001 (JP)**

(72) Inventor: **KOBAYASHI, Takafumi
Tokyo 108-8001 (JP)**

(74) Representative: **MacDougall, Alan John Shaw et al
Mathys & Squire LLP
The Shard
32 London Bridge Street
London SE1 9SG (GB)**

(54) **CONTROL CIRCUIT AND CONTROL METHOD**

(57)    The present invention addresses the problem of many man-hours being required for a hardware engineer to adjust a resistance value such that the rise time of a signal input to an LSI body falls within a defined range. To solve this problem, the present invention provides a control circuit provided with: a conductive wire for transmitting an input electric signal to an integrated circuit; a resistance circuit which has a variable resistance value and which is connected to the conductive wire and grounded; a measurement means for measuring a rise time of the electric signal transmitted through the conductive wire, that is, the amount of time it takes for the voltage value of the electric signal to reach a predetermined second voltage value from a predetermined first voltage value, said predetermined second voltage value being higher than the first voltage value; and a control means for changing the resistance value of the resistance circuit to a value which is lower by a specific amount when the time measured by the measurement means is shorter than the minimum time of a predetermined time range, and changing the resistance value to a value which is higher by a specific amount when the time measured by the measurement means is longer than the maximum time of the predetermined time range. The control means outputs a predetermined signal upon having changed the resistance value a predetermined number of times.

Fig. 6

CONFIGURATION EXAMPLE OF CONTROL CIRCUIT IN
SECOND EXAMPLE EMBODIMENT

**Description**

[Technical Field]

The present invention relates to a control circuit and a control method, and particularly to a control circuit and a control method which are for adjusting a resistance value.

[Background Art]

In general, a high frequency signal input to an LSI (Large Scale Integration) must have a rise time and a fall time within a time range (for example, 100 to 500 ns) specified by LSI manufacturers. The reason is that LSIs are likely to operate falsely. The high frequency signal is a signal having a wavelength shorter than the length of a wire connecting a signal source generating the high frequency signal to the LSI.

Hardware engineers carrying out board design by using an LSI place a Thevenin terminating circuit or a pull-down resistor at a pre-stage of the LSI and adjust its resistance value so that a high frequency signal having a rise time and a fall time within a specified time range may be input to the LSI. In this instance, hardware engineers check the waveform of the high frequency signal input to the LSI by, for example, an oscilloscope, and if the rise time and the fall time are not within the specified time range, they repeat changing the resistance value and checking whether the values have fallen within the specified time range or not. There has been a problem that many development man-hours are required because the hardware engineer carries out manually the adjustment of the resistance value for all LSIs to be mounted on an electronic board.

Patent Literature 1 below discloses an art relating to the above problem.

A control circuit of Patent Literature 1 is provided with a determination means and a control means. The determination means determines whether an input signal overshoots or undershoots. In other words, the determination means determines whether the amplitude of the input signal exceeds (overshoots) a first threshold (voltage value) or falls below (undershoots) a second threshold (voltage value). When the input signal overshoots or undershoots, the control means switches the resistance value of a terminal resistor within a memory to a larger value and reduces the amplitude of the input signal. The control circuit of Patent Literature 1 can reduce the overshoot or the undershoot of the input signal.

As in the above-mentioned configuration and operation, since the control circuit in Patent Literature 1 obtains automatically the resistance value for reducing the overshoot or the undershoot, hardware engineers can eliminate development man-hours to adjust the resistance value.

Patent Literature 2 describes a circuit which gradually turns on a plurality of resistive elements to avoid a drastic current change generated by the turn-on of the elements. Patent Literature 3 describes a circuit which turns on a transistor in response to temperature variation, to keep constant the waveform of an output signal.

[Citation List]

[PTL 1] Japanese Patent Laid-Open No. JP 2011-81733
[PTL 2] Japanese Patent Laid-Open No. JP 2009-152865
[PTL 3] Japanese Patent Laid-Open No. JP 2008-182516

[Summary of Invention]

[Technical Problem]

However, there still remains a problem that hardware engineers require to spend many development man-hours to adjust the resistance value so that the rise time and the fall time of a high frequency signal input to an LSI (hereinafter, referred to as 'input signal') may be within a specified range.

The reason is that, although the control circuit of Patent Literature 1 adjusts the resistance value so that the overshoot, etc. may be reduced, it neither carries out the adjustment which makes the rise time and the fall time of an input signal fall within a specified range, nor informs a hardware engineer whether the times have fallen within the specified range or not. Accordingly, even if the hardware engineer uses the control circuit of Patent Literature 1, he/she can neither expect that the rise time and the fall time of the input signal fall within the specified range, nor distinguish an accidental falling of the times within the specified range even if it happens. As a result, hardware engineers still have to adjust manually the resistance value for all LSIs mounted on an electronic board, spending many development man-hours for the adjustment.

In addition, although the circuits in Patent Literatures 2 and 3 gradually turn on the resistive elements and turn on the transistor in response to temperature variation, they do not carry out a control of adjustment which makes the rise time and so on of an input signal input to an LSI fall within the specified range. As a result, even if hardware engineers use the circuits in Patent Literatures 2 and 3, they can neither expect that the rise time and so on of the input signal fall within the specified range, nor distinguish an accidental falling of the times within the specified range even if it happens. Hardware engineers have to adjust manually the resistance value for all LSIs on an electronic board, spending many development man-hours for the adjustment.

The present invention aims to provide a control circuit and a control method that solves the above-described problems.

[Solution to Problem]

To achieve the above-described object, a control circuit of the present invention comprises: a conductive wire for transmitting an input electric signal to a connected integrated circuit; a resistor circuit connected to the conductive wire and grounded, the resistance value of which is variable; a measuring means for measuring one of or both of a rise time and a fall time, the rise time being taken for a voltage value of the electric signal transmitted through the conductive wire across the resistor circuit and the integrated circuit to rise from a predetermined first voltage value up to a predetermined second voltage value larger than the first voltage value, and the fall time being taken for the voltage value of the signal to fall from a predetermined third voltage value down to a predetermined fourth voltage value smaller than the third voltage value; and a control means for changing a resistance value of the resistor circuit to a smaller value by a certain amount when at least one of the times measured by the measuring means is shorter than a minimum time of a predetermined time range, and to a larger value by a certain amount when at least one of the times measured by the measuring means is longer than a maximum time of the predetermined time range, wherein the control means outputs a predetermined signal in response to changing the resistance value a predetermined number of times.

To achieve the above-described object, a control method of the present invention comprises: measuring one of or both of a rise time and a fall time, the rise time being taken for a voltage value of an electric signal to rise from a predetermined first voltage value up to a predetermined second voltage value larger than the first voltage value, the fall time being taken for the voltage value of the electric signal to fall from a predetermined third voltage value down to a fourth voltage value smaller than the third voltage value, and the voltage value of the electric signal being transmitted through a conductive wire across an integrated circuit and a resistor circuit which is connected to the conductive wire connected to the integrated circuit and is grounded, the resistance value of which resistor circuit is a variable resistance value; changing the resistance value of the resistor circuit to a smaller value by a certain amount when at least one of the measured times is shorter than a minimum time of a predetermined time range, and to a larger value by the certain amount when at least one of the measured times is longer than a maximum time of the predetermined time range; and outputting a predetermined signal in response to changing the resistance value the predetermined number of times.

[Advantageous Effects of Invention]

According to the present invention, hardware engineers can reduce effort to adjust the resistance value so that the rise time and the fall time of a high frequency signal input to an LSI may be within a specified range, thereby reducing development man-hours for the adjustment.

[Brief Description of Drawings]

[FIG. 1] Fig. 1 is a diagram showing a configuration example of an LSI including a control circuit in a first example embodiment of the present invention.

[FIG. 2] Fig. 2 is a diagram for explaining a function of a pull-down resistor circuit provided in the control circuit in the first example embodiment of the present invention.

[FIG. 3] Fig. 3 is a chart for explaining a rise time and a fall time controlled by the control circuit in the first example embodiment of the present invention.

[FIG. 4] Fig. 4 is a diagram for explaining a reflection coefficient used in the control circuit in the first example embodiment of the present invention.

[Fig. 5A] Fig. 5A is a chart showing an operation of the control circuit in the first example embodiment of the present invention.

[Fig. 5B] Fig. 5B is a chart showing an operation of the control circuit in the first example embodiment of the present invention (operation following the operation in Fig. 5A).

[FIG. 6] Fig. 6 is a diagram showing a configuration example of a control circuit in a second example embodiment of the present invention.

[Description of Embodiments]

Next, example embodiments of the present invention will be described in detail with reference to the drawings.

«First Example Embodiment»

[Overview]

The control circuit of this example embodiment is included in an LSI (Large Scale Integration) and provided with a pull-down resistor circuit having a variable resistance value. The pull-down resistor circuit is connected to a conductive wire through which an input high frequency signal is transmitted to the LSI main body, and the circuit is grounded. The control circuit of this example embodiment changes the resistance value of the pull-down resistor circuit so that a rise time and fall time of the signal input to the LSI main body may be within a specified range. The control circuit of this example embodiment outputs an ALM (Alarm) signal to the outside of the LSI, when the rise time and the fall time do not fall within the specified range even after the resistance value of the pull-down resistor circuit was changed a predetermined number of times.

When LSIs including the control circuit of this example embodiment are mounted on an electronic board, hardware engineers only have to adjust the resistance value of an LSI which outputs the ALM signal. Hardware engineers do not necessarily have to adjust the resistance value for all of the LSIs mounted on the electronic board, and thereby can reduce development man-hours for the adjustment.

The configuration, function, and operation of an LSI including a control circuit of this example embodiment will now be described including a specific method of changing the resistance value of the pull-down resistor circuit.

[Description of Configuration]

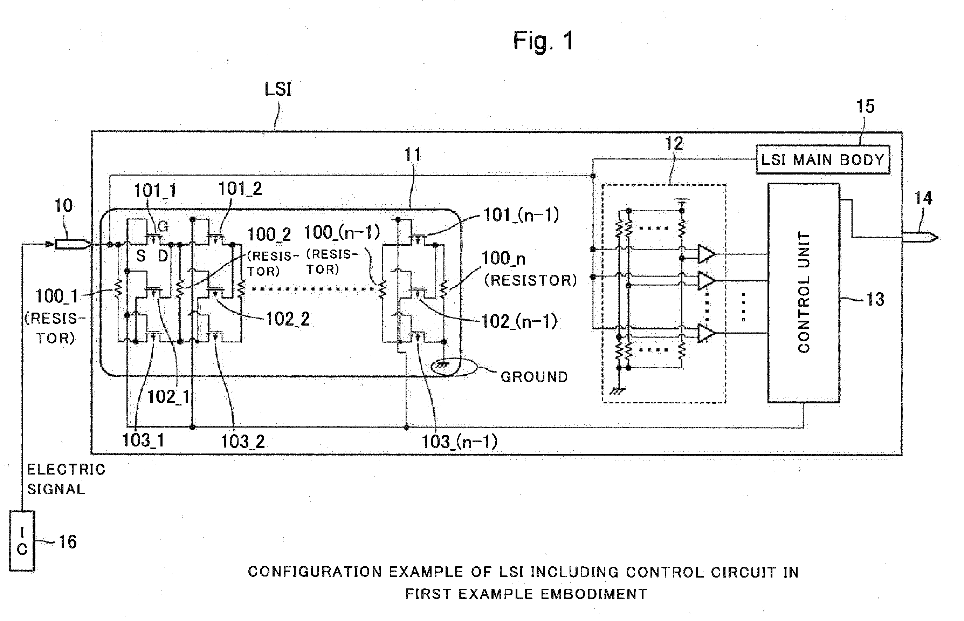

First, the configuration and function of an LSI including a control circuit in the first example embodiment of the present invention will be described. Fig. 1 is a diagram showing a configuration example of an LSI including a control circuit in the first example embodiment of the present invention.

(1) A configuration of an LSI including a control circuit in the first example embodiment of the present invention

The LSI including a control circuit of this example embodiment (hereinafter, referred to as 'LSI of this example embodiment') is, as shown in Fig. 1, provided with a signal-receiving terminal 10, a pull-down resistor circuit 11, a voltage detection circuit 12, a control unit 13, an ALM terminal 14, and an LSI main body 15. The control circuit of this example embodiment consists of the circuits other than the LSI main body 15 (i.e., the signal-receiving terminal 10, the pull-down resistor circuit 11, the voltage detection circuit 12, the control unit 13, and the ALM terminal 14).

The signal-receiving terminal 10 is connected to the LSI main body 15 by a conductive wire. To the conductive wire are also connected the pull-down resistor circuit 11 and the voltage detection circuit 12. The voltage detection circuit 12 is connected to the control unit 13. The control unit 13 is connected to the ALM terminal 14 and the pull-down resistor circuit 11. The pull-down resistor circuit 11 is grounded.

The signal-receiving terminal 10 is wired and connected to an IC (Integrated Circuit) 16 generating a high frequency signal. The high frequency signal is a signal having a very short wavelength (precisely, wavelength shorter than the length of the wire which connects the IC 16 to the signal-receiving terminal 10). The IC 16 may be an oscillator.

(2) A configuration of the pull-down resistor circuit 11 included in the control circuit of this example embodiment

The pull-down resistor circuit 11 is provided with a plurality of resistors 100_1 to 100_n (n is the number of resistors mounted on the pull-down resistor circuit 11) and FETs (Field Effect Transistors) 101_1 to 101_(n - 1). Further, the pull-down resistor circuit 11 is provided with FETs 102_1 to 102_(n - 1) and FETs 103_1 to 103_(n - 1).

Among resistors 100_1 to 100_n, resistors 100_k and 100_k + 1 adjacent to each other (k is an arbitrary integer between 1 and (n - 1)) are, as shown in Fig. 1, connected via an FET 101_k, an FET 102_k, and an FET 103_k.

The control unit 13 is connected to all FETs (hereinafter referred to as 'FETs 101_1 to 103_(n - 1)'). In Fig. 1, although a single identical wire is described as if it connects the control unit 13 to each of the FETs, different wires actually connect them.

(3) A function of each unit in the control circuit

(3-1) A function of the signal-receiving terminal 10

The signal-receiving terminal 10 is a general input terminal. The signal-receiving terminal 10 receives an electric signal, which is a high frequency signal, from the IC 16. The signal-receiving terminal 10, when receiving the electric signal, outputs the received electric signal to the pull-down resistor circuit 11, the voltage detection circuit 12, and the LSI main body 15.

(3-2) A function of the pull-down resistor circuit 11

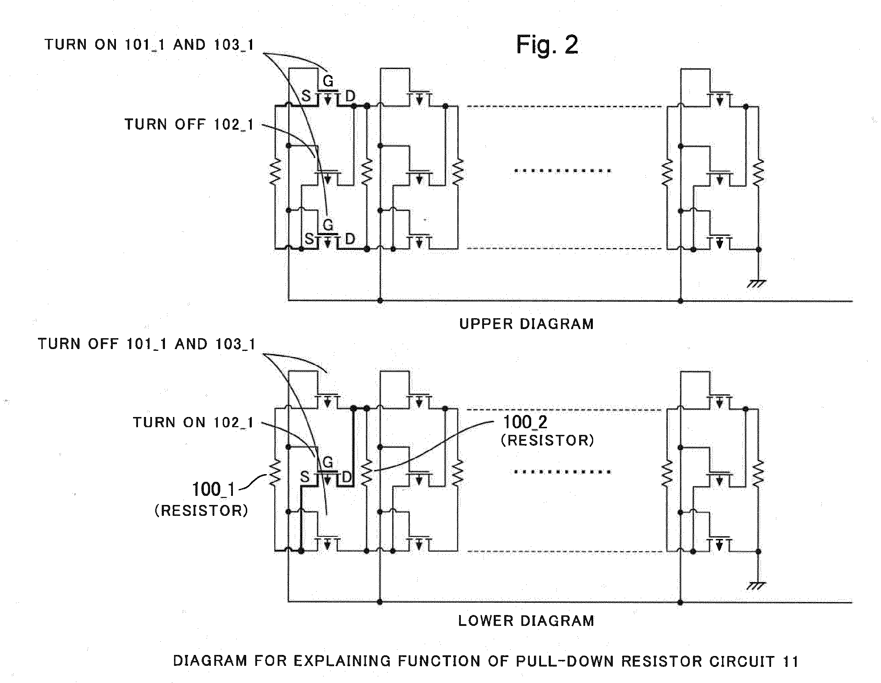

Fig. 2 is a diagram for explaining the function of the pull-down resistor circuit 11 included in the control circuit in the first example embodiment of the present invention.

Each of the FETs 101_1 to 103_(n - 1) is a general FET and carries out switching operation by a certain amount of voltage applied to its gate by the control unit 13. Specifically, each of the FETs 101_1 to 103_(n - 1) connects its source and its drain when the voltage is applied to its gate by the control unit 13. Reference signs 'G', 'S', and 'G' assigned to the FET 101_1 of Fig. 1 represents the gate, the source, and the drain. Each of the FETs 101_1 to 103_(n - 1) opens the electrical connection between its source and drain when the voltage is not applied to its gate by the control unit 13.

The FET 102_k (k is an arbitrary integer between 1 and (n - 1)) connects, in series, the resistor 100_k and the resistor 100_(k + 1) when a voltage is applied to its gate by the control unit 13 to connect its source and drain. For example, as shown in the lower diagram of Fig. 2, the FET 102_1 connects, in series, the resistor 100_1 and the resistor 100_2 when the voltage is applied to its gate by the control unit 13 to connect its source and drain. The FETs 102_1 to FET 102_(n-1) are FETs for series connection.

Similarly, the FETs 101_k and 103_k (k is an arbitrary integer between 1 and (n - 1)) connect, in parallel, the resistor 100_k and the resistor 100_(k + 1) when the voltage is applied to their gate by the control unit 13 to connect their source and drain. For example, as shown in the upper diagram of Fig. 2, the FET 101_1 and the FET 103_1 connect, in parallel, the resistor 100_1 and the resistor 100_2 when the voltage is applied to their gate by the control unit 13 to connect their source and drain. The FETs 101_1 to 101_(n - 1), and the FETs 103_1 to 103_(n - 1) are FETs for parallel connection.

As mentioned above, the pull-down resistor circuit 11 connects the resistors 100_1 to 100_n in series or in parallel owing to the voltage applied to each of the FETs 101_1 to 103_(n - 1) by the control unit 13. The pull-down resistor circuit 11 reconnects, in series, the resistor 100_k and the resistor 100_k + 1 which are in a state of being connected in parallel, and thereby increases the resistance value of itself (combined resistance value) by a certain amount in comparison to the parallel connection. The pull-down resistor circuit 11 reconnects, in parallel, the resistor 100_k and the resistor 100_k + 1 (k is an arbitrary integer between 1 and (n - 1)) which are in a state of being connected in series, and thereby decreases the resistance value of itself (combined resistance value) by a certain amount in comparison to the serial connection. The pull-down resistor circuit 11 has a function which reconnects the resistors 100_1 to 100_n in series or in parallel owing to the voltage applied to each of the FETs 101_1 to 103_(n - 1) by the control unit 13, thereby changing the resistance value of the circuit itself (combined resistance value).

(3-3) A function of the voltage detection circuit 12

The voltage detection circuit 12, when a predetermined timing is achieved, detects a voltage value of an input electric signal and outputs the detected voltage value as an electric signal to the control unit 13.

The above predetermined timing is a timing having a constant interval and is set to the voltage detection circuit 12 by an LSI manufacturer. Since the electric signal is a high frequency signal, the LSI manufacturer sets a time interval shorter than one cycle of the high frequency signal (for example, every several hundred $\mu$s) as the predetermined timing to the voltage detection circuit 12. The voltage detection circuit 12 may be provided with a general voltmeter or a comparator circuit, thereby detecting a voltage value of the input electric signal.

(3-4) With respect to the LSI main body 15

The LSI main body 15 is a general integrated circuit, into which is input an electric signal (high frequency signal).

For the LSI main body 15, the rise time and fall time of the input electric signal are specified as follows by an LSI manufacturer in this example embodiment.

- Rise time = time taken for voltage of input electric signal to rise from VIL up to VIH

- Fall time = time taken for the voltage of input electric signal to fall from VIH down to VIL

$$VIL = \text{value of operating voltage for LSI main body 15} \times \text{constant percentage A (for example 20\%)}$$

$$VIH = \text{value of operating voltage for LSI main body 15} \times \text{constant percentage B (for example 80\%)}$$

The value of the operating voltage is a voltage value necessary for the LSI main body 15 to operate and is, for example, 3.3V. The above percentage A is a value smaller than the percentage B.

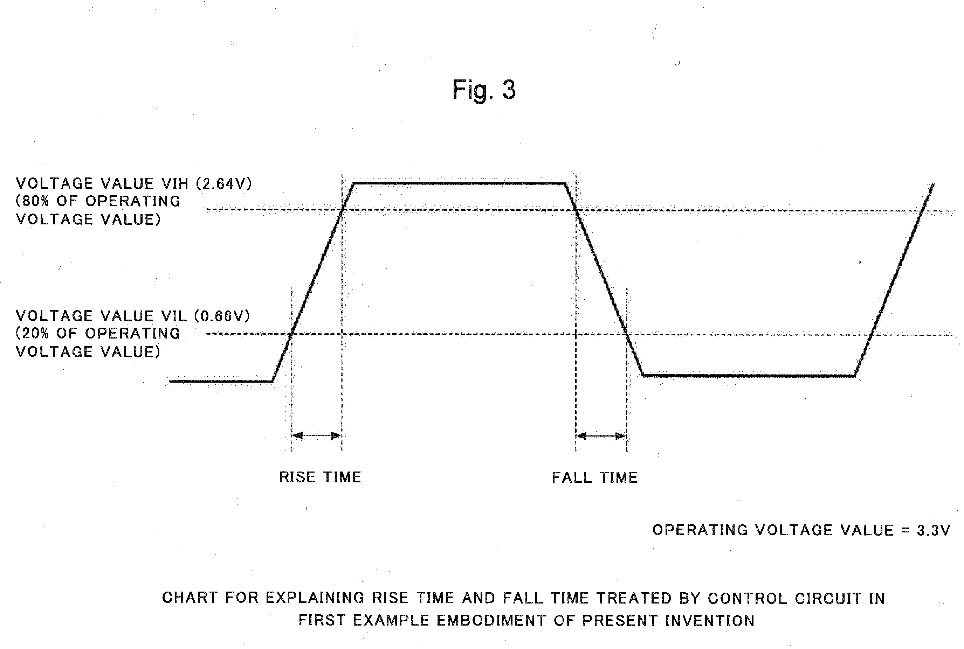

The above rise time may be, for example as shown in Fig. 3, a time taken for the voltage value to rise from VIL (0.66V) to VIH (2.64V). The above fall time may be, as shown in Fig. 3, a time taken for the voltage value to fall from VIH (2.64V) to VIL (0.66V). Fig. 3 is a chart for explaining the rise time and the fall time specified for the control circuit in the first example embodiment of the present invention. LSI manufacturers may put respective values of the specified VIL, VIH, the rise time, and so on into a form of data sheet for the LSI main body 15.

Further, for the LSI main body 15, LSI manufacturers specify a range of the above rise time (specifically a minimum time MIN_A of the rise time and a maximum time MAX_A of the rise time). Similarly, for the LSI main body 15, they specify a range of the fall time (specifically a maximum time MAX_B of the fall time and a minimum time MIN_B of the fall time). The maximum time MAX_A and the minimum time MIN_A are the longest time and the shortest time of the rise time, respectively. The maximum time MAX_B and the minimum time MIN_B are the longest time and the shortest time of the fall time, respectively. LSI manufacturers may put the maximum time MAX_A, the minimum time MIN_A, the maximum time MAX_B, and the minimum time MIN_B into a form of data sheet for the LSI main body 15.

(3-5) A function of the control unit 13

(3-5-1) A value preset to the control unit 13

The above VIL and VIH are preset to the control unit 13 by an LSI manufacturer in this example embodiment.
Further, the range of the rise time (maximum time MAX_A, minimum time MIN_A) and the range of the fall time (maximum time MAX_B and minimum time MIN_B) are preset to the control unit 13 by the LSI manufacturer in this example embodiment.

(3-5-2) A function of measuring the rise time and the fall time

The control unit 13 measures the rise time and the fall time of an electric signal input to the LSI, on the basis of a voltage value (of the electric signal) input from the voltage detection circuit 12.
Specifically, when the voltage value (of the electric signal) input from the voltage detection circuit 12 becomes VIL or higher, the control unit 13 starts a timekeeping function incorporated therein (hereinafter referred to as 'timer'), to initiate time measurement. The timer may be a high precision timer having picosecond precision, HPET (High Precision Event Timer). When the voltage value (of the electric signal) input from the voltage detection circuit 12 becomes VIH or higher, the control unit 13 stops the timer. The time measured by the timer in this step is the rise time. The control unit 13 can measure the rise time.
When the voltage value (of the electric signal) input from the voltage detection circuit 12 becomes VIH or lower, the control unit 13 starts the timer, to initiate time measurement. When the voltage value of the signal input from the voltage detection circuit 12 becomes VIL or lower, the control unit 13 stops the timer. The time measured by the timer in this step is the fall time. The control unit 13 can measure the fall time.

(3-5-3) A function of determining whether the rise time and the fall time are within a specified time range or not

The control unit 13 determines whether the measured rise and fall times are within a specified time range or not. Specifically, the control unit 13 determines whether the measured rise time is a time between the above minimum time MIN_A and the maximum time MAX_A or not. Similarly, the control unit 13 determines whether the measured fall time is a time between the above minimum time MIN_B and the maximum time MAX_B or not.
When the control unit 13 determines that the rise time is not a time between the above minimum time MIN_A and maximum time MAX_A, it determines whether the rise time is longer than the maximum time MAX_A or shorter than the minimum time MIN_A. Similarly, when the control unit 13 determines that the fall time is not a time between the minimum time MIN_B and the maximum time MAX_B, it determines whether the fall time is longer than the maximum time MAX_B or shorter than the minimum time MIN_B.

(3-5-4) A function of adjusting the resistance value

When the rise time is longer than the maximum time MAX_A, the control unit 13 carries out a control of increasing a resistance value of the pull-down resistor circuit 11, to shorten the rise time. Similarly, when the fall time is longer than the maximum time MAX_B, the control unit 13 carries out a control of increasing a resistance value of the pull-down resistor circuit 11, to shorten the fall time. The reason why the increase in the resistance value of the pull-down resistor circuit leads to the shortening of the rise time and the fall time will be described below in '(3-7) With respect to the rise time and the fall time.'

The control of increasing the resistance value of the above pull-down resistor circuit 11 is achieved by the control unit 13 applying a certain amount of voltage to the gate of the FET 102_1 for series connection. In this instance, the control unit 13 does not apply the voltage to the gates of the FET 101_1 and the FET 103_1 for parallel connection. When the control unit 13 is already in a state of applying the voltage to the gate of the FET 102_1, it applies the voltage to the gate of the other FET 102_y (y is any number from 2 to n) for series connection. In this instance, the control unit 13 does not apply the voltage to the gates of the FET 101_y and the FET 103_y for parallel connection.

Further, when the rise time is shorter than the minimum time MIN_A, the control unit 13 carries out a control of decreasing the resistance value of the pull-down resistor circuit 11, to prolong the rise time. Similarly, when the fall time is shorter than the minimum time MIN_B, the control unit 13 carries out a control of decreasing the resistance value of the pull-down resistor circuit 11, to prolong the fall time. The reason why the decrease in the resistance value of the pull-down resistor circuit leads to the prolongation of the rise time and the fall time will be described below in '(3-7) With respect to the rise time and the fall time.'

The control of decreasing the resistance value of the above pull-down resistor circuit 11 is achieved by the control unit 13 applying a certain amount of voltage to the gates of the FET 101_1 and the FET_103_1 for parallel connection. In this instance, the control unit 13 does not apply the voltage to the gate of the FET 102_1 for series connection. When the control unit 13 is already in a state of applying a certain amount of voltage to the gates of the FET 101_1 and the FET 103_1, it applies the voltage to the gates of the other FETs 101_y and 103_y (y is any number from 2 to n) for parallel connection. In this instance, the control unit 13 does not apply the voltage to the gate of the FET 102_y for series connection.

(3-5-5) A function of counting the number of times of adjustment

The control unit 13 increments a value of a counter incorporated therein by one after carrying out the control of increasing or decreasing the resistance value of the pull-down resistor circuit 11 (i.e., adjustment of the resistance value). This counter is a counter for counting the number of times of adjusting the resistance value of the pull-down resistor circuit, and a default value of the number is 0.

The control unit 13 determines whether or not the counter value, i.e., the number of times of adjusting the resistance value of the pull-down resistor circuit 11 reaches a predetermined maximum number of trials. The predetermined maximum number of trials is a value preset to the control unit 13 by an LSI manufacturer in this example embodiment.

When the counter value (the number of times of adjusting the resistance value) is the predetermined maximum number of trials, the control unit 13 outputs an alarming electric signal (hereinafter, referred to as 'ALM signal') to the ALM terminal 14. This is for informing a hardware engineer carrying out hardware design by using the LSI of this example embodiment, that even after the repeated adjustment of the resistance value, the rise time and the fall time of the input signal failed to fall within the specified range.

When the counter value (the number of times of changing the resistance value) is not the predetermined maximum number of trials, the control unit 13 carries out the above functions (3-5-2) to (3-5-4). When the rise time becomes a time between the minimum time MIN_A and the maximum time MAX_A, and the fall time becomes a time between the minimum time MIN_B and the maximum time MAX_B, the control unit 13 stops the processing.

The control unit 13 can be actualized by using an electronic circuit, a memory such as a RAM (Random Access Memory), and a general microcomputer.

(3-6) A function of the ALM terminal 14

The ALM terminal 14 is a general output terminal, which outputs an ALM signal input from the control unit 13 to the outside of the LSI of this example embodiment.

A red LED (Light Emitting Diode) may be connected to the ALM terminal 14. In this instance, the ALM terminal 14 outputs a current to the LED upon the input of the ALM signal. While the current is being supplied from the ALM terminal 14, the red LED continues emitting red light, to inform the hardware engineer carrying out the design by using the LSI that the resistance value failed to be adjusted.

(3-7) With respect to the rise time and the fall time

(3-7-1) The reason why the rise time and the fall time are shortened

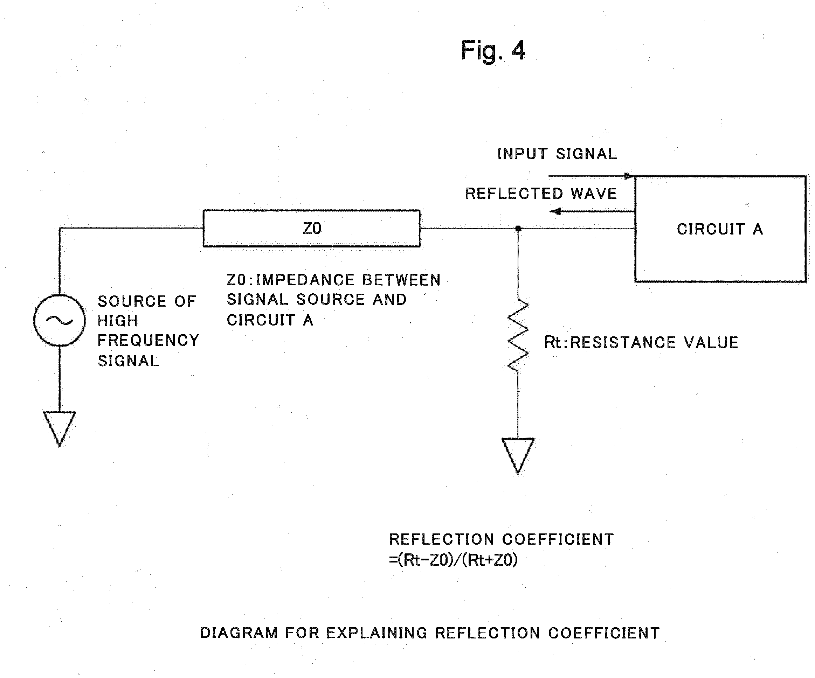

Fig. 4 is a diagram for explaining a reflection coefficient used in the control circuit in the first example embodiment of the present invention. As a general discussion, the reason will now be described why the increase in the resistance value of the pull-down resistor circuit leads to the shortening of the rise time and the fall time.

First, since an electric signal input to the LSI main body 15 is a high frequency signal (wave), it generally creates a reflected wave from the LSI main body 15, and the waveform of the input signal (hereinafter, referred to as 'LSI input signal') to the LSI main body 15 is combined with that of the reflected wave. The extent of the reflection by the LSI main body 15 is represented by a reflection coefficient. In general, a larger reflection coefficient means the existence of a larger reflected wave, which makes the waveform of the LSI input signal combined therewith have a large amplitude (voltage value) and the rise time and the fall time of the LSI input signal be faster (shorter).

For the circuit shown in Fig. 4, the reflection coefficient ($\Gamma$) is known to be generally represented by the formula 1 below.

$$\text{Reflection coefficient } (\Gamma) = (Rt - Z0) / (Rt + Z0) \cdots (\text{formula 1})$$

The above formula 1 indicates that a larger resistance value Rt of a pull-down resistor leads to a larger reflection coefficient ($\Gamma$).

The LSI of this example embodiment is a circuit having the same configuration as that of the circuit in Fig. 4. The pull-down resistor circuit 11 corresponds to the resistor shown in Fig. 4, and the LSI main body 15 corresponds to the circuit A shown in Fig. 4.

For this reason, the LSI of this example embodiment has a reflection coefficient ($\Gamma$) increasing with the increase in the resistance value Rt of the pull-down resistor. In other words, in the LSI of this example embodiment, a larger resistance value Rt of the pull-down resistor leads to the existence of a larger reflected wave and the shortening of the rise time and the fall time of the LSI input signal.

(3-7-2) The reason why the rise time and the fall time prolong

The reason will now be described why the decrease in the resistance value of the pull-down resistor circuit leads to the prolongation of the rise time and the fall time.

First, as described above, the waveform of an LSI input signal input to the LSI main body 15 is a waveform combined with that of the reflected wave. The extent of the reflection is represented by the reflection coefficient. In general, a smaller reflection coefficient leads to a smaller reflected wave, which makes the rise time and the fall time of the LSI input signal with which is combined the reflected wave be slower (longer).

Since the LSI of this example embodiment is a circuit having the same configuration as that of the circuit shown in Fig. 4, it has a reflection coefficient ($\Gamma$) decreasing with the decrease in the resistance value Rt of the pull-down resistor. In other words, in the LSI of this example embodiment, the rise time and the fall time of the LSI input signal becomes slower (longer) with the decrease in the resistance value Rt of the pull-down resistor.

[Description of operations]

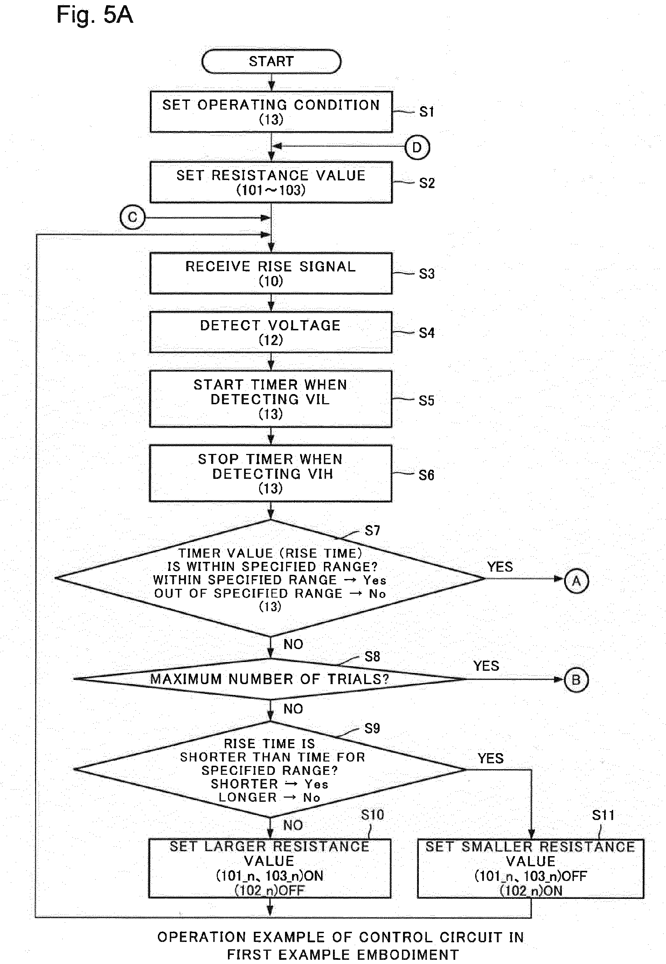

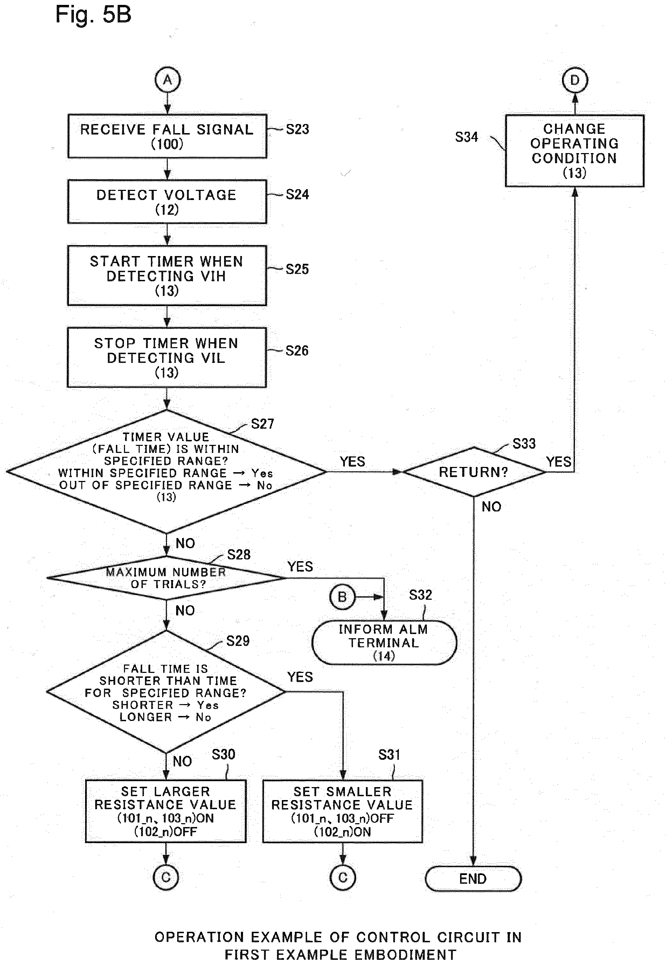

Fig. 5A and Fig. 5B are charts for explaining operations of the control circuit in the first example embodiment of the present invention. The detailed operations of the system of this example embodiment will be described by using Fig. 5A and Fig. 5B.

(1) With respect to presetting

First, as shown in Fig. 5A, a LSI manufacturer in this example embodiment presets the above voltage value (VIL, VIH) and the rise time range (the maximum time MAX_A and the minimum time MIN_A) to the control unit 13 of the control circuit of this example embodiment (S1). In addition, the LSI manufacturer in this example embodiment presets the fall time range (the maximum time MAX_B and the minimum time MIN_B) to the control unit 13.

When the control unit 13 is actualized by a general microcomputer, a hardware engineer can set the above-mentioned various values to the microcomputer (control unit 13) by using a general software for development in integrated environment.

The hardware engineer may check a data sheet of the LSI main body 15 and preset various values such as VIL above to the microcomputer, for example, at the time of factory shipment of the circuit.

(2) An operation of setting the resistance value

Next, the control unit 13 applies voltage to the gate of any one of the FETs 101_1 to 103_(n - 1), to set an arbitrary resistance value to the pull-down resistor circuit 11 (S2).

Specifically, the control unit 13 applies the voltage to the gate of an FET 102_k (k is any one from 1 to (n - 1)) optionally selected from the FETs 102_1 to 102_(n - 1) for series connection. In this instance, the control unit 13 does not apply the voltage to the gate of FETs 101_k and 103_k for parallel connection. Further, in order to connect the pull-down resistor circuit 11 to ground, the control unit 13 applies the voltage to the gate of all FETs 101_z and 103_z (z is 1 to (n - 1) other than k) for parallel connection other than the FETs 101_k and 103_k for parallel connection.

(3) An operation of measuring the rise time

Next, an electric signal which is a high frequency signal is supposed to be input from the IC 16 to a LSI of this example embodiment, although it is not illustrated.

In this instance, the signal-receiving terminal 10 of the LSI of this example embodiment outputs, to the voltage detection circuit 12, the received electric signal (high frequency signal) input from the IC 16 (S3).

The voltage detection circuit 12 detects, at every predetermined timing, the voltage value of the input electric signal and outputs the detected voltage value to the control unit 13 (S4).

The predetermined timing is a timing having a very short constant interval (for example, a timing of every several tens of ps). By the above step S4, the control unit 13 receives the voltage value of the electric signal (high frequency signal) input from the voltage detection circuit 12.

Then, when the voltage value (of electric signal) input from the voltage detection circuit 12 becomes VIL or higher, the control unit 13 starts a timekeeping function incorporated therein (i.e., timer), to initiate time measurement (S5).

The timer may be a high precision timer having picosecond precision, HPET (High Precision Event Timer).

Then, when the voltage value (of the electric signal) input from the voltage detection circuit 12 becomes VIH or higher, the control unit 13 stops the timer (S6).

The time measured by the timer in this step is the rise time. The control unit 13 can measure the rise time.

(4) Determination whether the rise time is within a specified range or not

Then, the control unit 13 determines whether the time measured by the timer (i.e., rise time) is within a specified time range (S7).

Specifically, the control unit 13 determines whether the rise time measured by the timer is a time between the predetermined minimum time MIN_A and the maximum time MAX_A.

(5) Processing such as changing the resistance value when the rise time is not within the specified range

(5-1) Determination of whether the resistance value was adjusted a predetermined number of times or not

Next, when the rise time is not within the specified time range (No in S7), the control unit 13 determines whether the number of times of adjusting the resistance value of the pull-down resistor circuit 11 (the value of a counter operating in S10, S11, S30, and S31 below) has reached a maximum number of trials or not (S8).

The maximum number of trials is a value preset to the control unit 13 by an LSI manufacturer in this example embodiment.

Then, when the number of times of adjusting the resistance value of the pull-down resistor circuit 11 is not the maximum number of trials (No in S8), the control unit 13 determines whether the rise time obtained in the above step S6 is longer than the maximum time MAX_A or shorter than the minimum time MIN_A (S9).

For example, when the maximum time MAX_A, the minimum time MIN_A, and the rise time obtained in the above steps S5 and S6 are 500ps, 100ps, and 700ps, respectively, the control unit 13 determines that the rise time is longer than the maximum time MAX_A. If the rise time obtained in the above step S6 is 80ps, the control unit 13 determines that the rise time is shorter than the minimum time MIN_A.

(5-2) Processing of changing the resistance value when the rise time is longer than the maximum time MAX_A

Next, when the control unit 13 determines, in the above step S9, that the rise time is longer than the maximum time MAX_A (No in S9), it carries out a control of increasing the resistance value of the pull-down resistor circuit 11 so as to shorten the rise time (S10).

Specifically, when the control unit 13 determines that the rise time is longer than the maximum time MAX_A, it applies a constant amount of voltage to the gate of the FET 102_1 for series connection. When the control unit 13 is already in a state of applying the voltage to the gate of the FET 102_1, it applies the voltage to any one of the gates of the other FETs 102_y (y is an arbitrary integer between 2 and (n - 1)) for series connection. In this instance, the control unit 13 does not apply the voltage to the gate of a FET 101_y and a FET 103_y for parallel connection. As a result, the control unit 13 can connect a resistor 100_y and a resistor 100_(y + 1) in series and increase the resistance value (combined resistance value) of the pull-down resistor circuit 11 by a certain amount. The control unit 13 shortens the rise time of the electric signal (high frequency signal) by increasing the resistance value (combined resistance value) of the pull-down resistor circuit 11 by a certain amount. As described in the above section '(3-7) With respect to the rise time and the fall time', the increase in the resistance value of the pull-down resistor circuit 11 enables shortening the rise time of the electric signal (high frequency signal).

After carrying out the above step S10, the control unit 13 increments by one the value of the counter incorporated therein and temporarily stops the processing, although it is not illustrated. The above counter counts the number of times of adjusting the resistance value of the pull-down resistor circuit. A default value of the counter is 0.

Then, when an electric signal is input from the connected IC 16, the control circuit of this example embodiment again carries out the processing of the above step S3 or later.

(5-3) Processing of changing the resistance value when the rise time is shorter than the minimum time MIN_A

When the control unit 13 determines, in the above step S9, that the rise time is shorter than the minimum time MIN_A (Yes in S9), it carries out a control of decreasing the resistance value of the pull-down resistor circuit 11, so as to prolong the rise time (S11).

Specifically, when the control unit 13 determines that the rise time is shorter than the minimum time MIN_A, it applies a certain amount of voltage to the gate of the FET 101_1 and the FET 103_1 for parallel connection. When the control unit 13 is already in a state of applying the voltage to the gate of the FET 101_1 and the FET 103_1, it applies the voltage to any one of the gates of the other FETs 101_y and 103_y (y is an arbitrary integer between 2 and (n - 1)) for parallel connection. In this instance, the control unit 13 does not apply the voltage to the gate of the FET 102_y for series connection. As a result, the control unit 13 can connect the resistor 100_y and the resistor 100_(y + 1) in parallel and decrease the resistance value (combined resistance value) of the pull-down resistor circuit 11 by a certain amount. The control unit 13 prolongs the rise time of the electric signal (high frequency signal) by decreasing the resistance value (combined resistance value) of the pull-down resistor circuit 11 by a certain amount. As described in the above section '(3-7) With respect to the rise time and the fall time', the decrease in the resistance value of the pull-down resistor circuit 11 enables prolonging the rise time of the electric signal (high frequency signal).

After carrying out the step S11, the control unit 13 increments by one the value of the counter incorporated therein and then temporarily stops the processing. This counter is a counter for counting the number of times of adjusting the resistance value of the pull-down resistor circuit.

Then, when an electric signal is input from the connected IC 16, the control circuit of this example embodiment repeats the above steps of S3 to S11 again.

(5-4) Processing carried out when the maximum number of trials is reached in the above step S8

As a result of the repetition of the above steps of S3 to S 11, when the counter value (i.e., the number of times of adjusting the resistance value) reaches the predetermined maximum number of trials in the above step S8 (Yes in S8), the control unit 13 outputs an alarming electric signal to the ALM terminal 14 (S32). The step S32 is shown in Fig. 5B.

The above ALM terminal 14 outputs, to the outside of the LSI, the alarming electric signal (i.e., ALM signal) input from control unit 13 and informs a hardware engineer carrying out design by using the LSI that the resistance value failed to be adjusted. The ALM terminal 14 may be provided with a lighting unit which turns on a red LED upon the input of the ALM signal (electric signal). The lighting unit upon receiving the input ALM signal informs the hardware engineer that the resistance value failed to be adjusted. The lighting unit may be a circuit which is provided with a battery, an LED, and a switch which connects the battery and the LED when an electric signal is input to the unit.

(6) Processing of measuring the fall time

In the determination in the above step S7, when the rise time is within the specified time range (Yes in S7), the control unit 13 temporarily stops the processing, although it is not illustrated.

Then, an electric signal (high frequency signal) is supposed to be always input from the IC 16 to the signal-receiving terminal 10 of the control circuit of this example embodiment.

In this instance, as in the case of the above step S3 and as shown in Fig. 5B, the signal-receiving terminal 10 outputs the input signal to the voltage detection circuit 12 (S23).

The voltage detection circuit 12, as in the case of the above step S4, detects the voltage value of the input electric signal and outputs the detected voltage value to the control unit 13, at every predetermined timing (S24).

The predetermined timing is a timing having a very short constant interval (for example a timing of every several tens of ps). By the above step S24, a voltage value of the electric signal (high frequency signal) is input from the voltage detection circuit 12 to the control unit 13.

Next, when the voltage value (of electric signal) input from the voltage detection circuit 12 becomes VIH or lower, the control unit 13 starts the timekeeping function incorporated therein (i.e. timer), to initiate time measurement (S25).

Next, when the voltage value (of the electric signal) input from the voltage detection circuit 12 becomes VIL or lower, the control unit 13 stops the timer (S26).

The time measured by the timer in this step is the fall time. The control unit 13 can measure the fall time.

(7) Determination whether the rise time is within the specified range or not

Next, as in the case of the above step S7, the control unit 13 determines whether the time measured by the timer (i.e., fall time) is within the specified time range (S27).

Specifically, the control unit 13 determines whether the fall time measured by the timer is a time between the minimum time MIN_B and the maximum time MAX_B.

(8) Processing of changing the resistance value when the fall time is not within the specified range, and others

(8-1) Determination of whether the resistance value was adjusted a predetermined number of times or not

Next, when the fall time is not within the specified time range (No in S27), the control unit 13, as in the case of the above step S8, determines whether the number of times of adjusting the resistance value of the pull-down resistor circuit (value of the counter operating in the above steps S10 and S11) has reached the maximum number of trials (S28).

Next, when the number of times of adjusting the resistance value does not reach the maximum number of trials (No in S28), the control unit 13 determines whether the fall time obtained in the above steps S25 and S26 is longer than the maximum time MAX_B or shorter than the minimum time MIN_B (S29).

(8-2) Processing of changing the resistance value when the fall time is longer than the maximum time MAX_B

Next, when the control unit 13 determines that the fall time is longer than the maximum time MAX_B in the above step S29 (No in S29), it carries out a control of increasing the resistance value of the pull-down resistor circuit 11 so as to shorten the fall time (S30).

Specifically, the control unit 13 carries out the same processing as in the above step S10. In addition, after carrying out the same processing as in the above step S10, the control unit 13 increments by one the value of the counter incorporated therein. This is for counting the number of times of adjusting the resistance value of the pull-down resistor circuit.

(8-3) Processing of changing the resistance value when the rise time is shorter than the minimum time MIN_B

Next, when the control unit 13 determines that the fall time is shorter than the minimum time MIN_B in the above step S29 (Yes in S29), it carries out a control of decreasing the resistance value of the pull-down resistor circuit 11 so as to prolong the fall time (S31).

Specifically, the control unit 13 carries out the same processing as in the above step S11. In addition, after carrying out the same processing as in the above step S11, the control unit 13 increments by one the value of the counter incorporated therein. This is for counting the number of times of adjusting the resistance value of the pull-down resistor circuit.

Then, for an electric signal input from the connected IC 16, the control circuit of this example embodiment repeats the steps of S3 to S31 and again determines whether both of the rise time and the fall time are within the specified time range or not.

(8-4) Processing carried out when the maximum number of trials is reached in the above step S28

As a result of the repetition of the above steps S3 to S31, when the control unit 13 determines that the counter value (i.e. number of times of adjusting the resistance value) reaches the maximum number of trials (Yes in S28) in the above step S28, it outputs an ALM signal to the ALM terminal 14, as in the case of the above step S8 (S32).

The ALM terminal 14 outputs, to the outside of the LSI, an alarming electric signal (i.e., ALM signal) input from the control unit 13 and informs a hardware engineer carrying out design by using the LSI that the resistance value failed to be adjusted, although it is not illustrated. The ALM terminal 14 may be provided with a lighting unit which turns on a red LED upon the input of the ALM signal (electric signal). The lighting unit upon receiving the input ALM signal turns on the red LED to inform the hardware engineer that the resistance value failed to be adjusted.

(9) Processing which may be carried out after the rise time and the fall time fell within the specified range

(9-1) Processing of determining whether to stop or continue processing steps and processing of changing parameters.

When the fall time is within the specified time range in the above step S27 (Yes in S27), the control unit 13 determines whether or not to restart the above processing steps S2 to S32 (S33).

Specifically, the control unit 13 outputs, at every predetermined interval, a signal blinking the LED for a predetermined time (hereinafter referred to as 'blinking signal') to the ALM terminal 14 and determines whether a signal for restarting the processing steps is input or not until the predetermined time elapses.

The ALM terminal 14 may blink the connected red LED during the repeated input of the blinking signal from the control unit 13 at every predetermined interval, so as to encourage a hardware engineer carrying out design by using the LSI of this example embodiment to determine whether or not to carry out again the above steps S2 to S32. The control unit 13 is connected to a restart button which, when pressed, outputs a signal indicating the processing restart to the control unit 13, although the button is not illustrated. When the hardware engineer wants to carry out again the above steps S2 to S32, he/she presses the restart button during the blinking of the red LED, to input a signal indicating the processing restart to the control unit 13. The predetermined time is preset to the control unit 13 by an LSI manufacturer. The predetermined time is preferably a sufficiently long time.

Next, when the signal indicating processing restart is not input until the predetermined time elapses, in the step S33 (No in S33), the control unit 13 stops the processing.

On the other hand, when a signal indicating the processing restart is input by the predetermined time elapses (Yes in S33), the control unit 13 stops outputting the blinking signal, returns to S2, applies voltage to each of the FETs, and then carries out again the steps S2 to S33.

When the control unit 13 operates by a microcomputer, the control unit 13 (microcomputer) may change the parameter values (i.e., VIL, VIH, the maximum time MAX_A, the minimum time MIN_A, the maximum time MAX_B, the minimum time MIN_B) before returning to S2 (S34).

Specifically, after executing the above step S33, the control unit 13 (microcomputer) waits for the input of the above-described parameter values for a certain amount of time. During the certain amount of time, the hardware engineer inputs the above parameter values to the control unit 13 (microcomputer) by using a general software for development in integrated environment. When the above parameter values are input, the control unit 13 (microcomputer) sets the input parameter values thereto and carries out again the steps S2 to S33. If no signal is input during the certain amount of waiting time, then the control unit 13 (microcomputer) carries out again the steps S2 to S33 without changing the parameter values.

The above-described step S34 can be carried out when the function of the control unit 13 is actualized by a microcomputer. Therefore, the control unit 13 may omit S34.

The control unit 13 may carry out the processing of the steps S3 to S34 when the restart button is pressed by a hardware engineer while the unit is waiting for the input of the parameter values for the certain amount of time in S34. In this instance, since the control unit 13 does not carry out S2, the resistance value of the pull-down resistor circuit 11 is not initialized, and the processing of the steps S3 to S 34 is carried out by using the same resistance value as before.

(9-2) With respect to S33

When the fall time is within the specified time range (Yes in S27), the control unit 13 may stop the processing without carrying out the above step S33.

(9-3) With respect to S3 to S11 and S23 to S31

Further, when the LSI main body 15 is a circuit which has only to make one of the rise time and the fall time fall within a specified range, the control circuit of this example embodiment may carry out either the steps S3 to S11 or the steps S23 to S31 repeatedly. In this instance, information selecting steps S3 to S11 or that selecting steps S23 to S31 is set to the control circuit of this example embodiment by an LSI manufacturer. The control circuit of this example embodiment carries out the steps S3 to S11 when the information selecting steps S3 to S11 is set thereto and the steps S23 to S31 when the information selecting steps S23 to S31 is set thereto.

(9-4) With respect to the control circuit of this example embodiment

In the above description, an example is described in which the control circuit of this example embodiment is provided in an LSI, but the circuit may be provided outside the LSI.

[Description of Advantageous effect]

According to this example embodiment, hardware engineers can reduce effort to adjust the resistance value so that the rise time and the fall time of a high frequency signal input to the LSI may fall within specified ranges, thereby reducing development man-hours.

The reason is that a control circuit included in the LSI of the this example embodiment adjusts the resistance value in order for the rise time and the fall time of a high frequency signal input to the LSI main body to fall within specified ranges, and that the circuit outputs an ALM signal when it fails to adjust the resistance value. Hardware engineers merely have to adjust the resistance value only for an LSI that is outputting an ALM signal among LSIs of this example embodiment mounted on an electronic board. Therefore, they do not necessarily have to adjust the resistance value for all of the LSIs mounted on the electronic board, and they can reduce effort to adjust the resistance value, thereby reducing development man-hours.

«Second Example Embodiment»

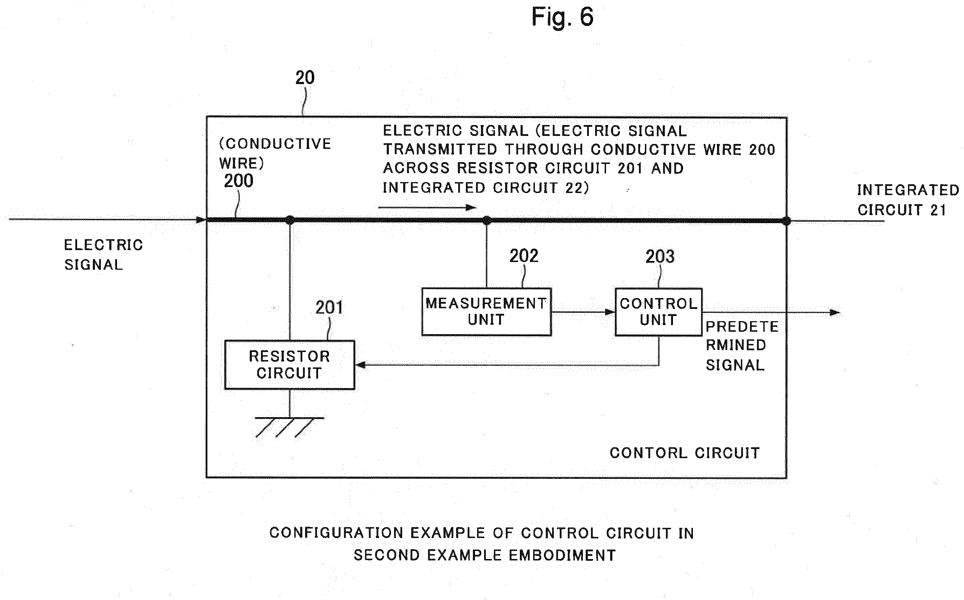

Fig. 6 is a diagram showing a configuration example of a control circuit according to a second example embodiment of the present invention. The configuration and operation of the control circuit of the second example embodiment will be described below.

[Description of the configuration]

(1) A configuration of the control circuit of the second example embodiment

The control circuit 20 of this example embodiment is connected to an integrated circuit 21, as shown in Fig. 6. The integrated circuit 21 may be a general LSI (Large Scale Integration).

Further, an electric signal is input to the control circuit 20 of this example embodiment, as shown in Fig. 6. The above electric signal may be a high frequency signal output from a general signal source.

The control circuit 20 of this example embodiment includes a conductive wire 200, a resistor circuit 201, a measurement unit 202, and a control unit 203, as shown in Fig. 6.

(2) The function of respective parts of the control circuit of this example embodiment

The conductive wire 200 is a conductive wire that transmits an input electric signal to the integrated circuit 21 to be connected.

The resistor circuit 201 is a circuit connected to the conductive wire 200 and is grounded, the resistance value of which is variable.

The measurement unit 202 measures both of or one of a rise time and a fall time, the rise time being taken for the voltage value of an electric signal transmitted through the conductive wire 200 across the resistor circuit 201 and the integrated circuit 21 to rise from a predetermined first voltage value up to a predetermined second voltage value, and the fall time being taken for the voltage value to fall from a predetermined third voltage value down to a predetermined fourth voltage value.

The above second voltage value is a voltage value larger than the above first voltage value. In addition, the above fourth voltage value is a voltage value smaller than the above third voltage value. Each of the first to fourth voltage values is set to the measurement unit 202 in advance by a hardware engineer using the control circuit 20 of this example embodiment.

The hardware engineer checks a data sheet of the integrated circuit 21 and sets, to the measurement unit 202, voltage values defining the rise time (for example, VIL, VIH described above in '(3-4) Function of the LSI main body 15' described above) as the first and second voltage values. In addition, the hardware engineer checks the data sheet of the integrated circuit 21 and sets, to the measurement unit 202, voltage values defining the fall time (for example, VIH, VIL) as the third and fourth voltage values.

When at least one of the times measured by the measurement unit 202 (for example, the rise time) is shorter than the minimum time of a predetermined time range, the control unit 203 changes a resistance value of the resistor circuit 201 to a smaller value by a certain amount. Further, when at least one of the times measured by the measurement unit 202 is longer than the maximum time of the predetermined time range, the control unit 203 changes the resistance value of the resistor circuit 201 to a larger value by a certain amount.

The hardware engineer checks the data sheet of the integrated circuit 21 and sets, to the control unit 203, a common time range within both of the time range of the specified rise time and that of the specified fall time, as a predetermined time range. Specifically, the hardware engineer sets, to the control unit 203, a minimum time and a maximum time within the common time range, as the minimum time and the maximum time of the predetermined time range. When the time range is 100 ns to 500 ns, the minimum time is 100 ns and the maximum time is 500 ns.

The control unit 203 outputs a predetermined signal in response to changing the resistance value of the resistor circuit 201 a predetermined number of times. For example, when the control unit 203 changes the resistance value of the resistor circuit 201 the predetermined number of times, it may output a signal indicating that the adjustment is impossible. The predetermined number of times is preset to the control unit 203 by the hardware engineer.

[Description of operations]

Next, operations of the system of this example embodiment will be described.

First, it is assumed that an electric signal (high frequency signal) is input to the control circuit 20 of this example embodiment from a connected signal source (not shown).

(I) In this instance, the measurement unit 202 of the control circuit 20 of this example embodiment measures a rise time taken for the voltage value of the electric signal transmitted through the conductive wire 200 across the resistor circuit 201 and the integrated circuit 22 to rise from the predetermined first voltage value up to the predetermined second voltage value.

(II) Next, when the rise time measured by the measurement unit 202 is shorter than the minimum time (for example, 100 ns) of the predetermined time range, the control unit 203 of the control circuit 20 of this example embodiment changes the resistance value of the resistor circuit 201 to a smaller value by a certain amount. This is for prolonging the rise time. Further, when the rise time measured by the measurement unit 202 is longer than the maximum time (for example, 500 ns) in the predetermined time range, the control unit 203 changes the resistance value of the resistor circuit 201 to a larger value by a certain amount. This is for shortening the rise time.

The measurement unit 202 and the control unit 203 repeat the above-described processing from (I) to (II).

(III) When the rise time does not fall within the predetermined time range even after changing the resistance value of the resistor circuit 201 by repeating, a predetermined number of times, the processing from (I) to (II) as described above, the control unit 203 outputs a signal indicating that adjustment is impossible.

The hardware engineer carrying out design by using the integrated circuit 21 can be informed, by the signal indicating the impossibility of the adjustment, that the control circuit 20 of this example embodiment failed to adjust the resistance value. Among a plurality of integrated circuits 21 on the board, the hardware engineer merely has to adjust the resistance value only for an integrated circuit 21 which is connected to the control circuit 20 of this example embodiment and outputs the signal indicating the impossibility of adjustment. The hardware engineer does not necessarily have to adjust the resistance value for all of the integrated circuits 21 on the board.

The measurement unit 202 may measure the fall time taken for the voltage value of the electric signal to fall from the predetermined third voltage value down to the predetermined fourth voltage value in the above-mentioned operation (I), instead of measuring the rise time. In this instance, when the measured fall time is shorter than the minimum time of the predetermined time range in the above-mentioned operation (II), the control unit 203 changes the resistance value of the resistor circuit 201 to a smaller value by a certain amount. When the fall time (measured by the measurement unit 202) is longer than the maximum time of the predetermined time range, the control unit 203 changes the resistance value of the resistor circuit 201 to a larger value by certain amount.

Further, the measurement unit 202 may measure both of the above rise time and the fall time in the above-mentioned operation (I). In this instance, that is, when the measurement unit 202 measures both of the rise time and the fall time, the control unit 203 carries out, in the above-mentioned operation (II), the following processing.

When at least one of the rise time and the fall time (measured by the measurement unit 202) is shorter than the minimum time of the predetermined time range, the control unit 203 changes the resistance value of the resistor circuit 201 to a smaller value by a certain amount. Further, when at least one of the rise time and the fall time (measured by the measurement unit 202) is longer than the maximum time of the predetermined time range, the control unit 203 changes the resistance value of the resistor circuit 201 to a larger value by a certain amount.

When the integrated circuit 21 described above specifies only the rise time, a hardware engineer may set, to the control unit 203, the time range of the specified rise time as a predetermined time range. Specifically, the hardware engineer sets a maximum time and a minimum time in the time range of the specified rise time to the control unit 203.

Similarly, when the integrated circuit 21 described above specifies only the fall time, the hardware engineer may set, to the control unit 203, the time range of the specified fall time as a predetermined time range. Specifically, the hardware engineer sets a maximum time and a minimum time in the time range of the specified fall time to the control unit 203.

[Description of effect]

According to this example embodiment, hardware engineers can reduce effort to adjust the resistance value so that the rise time and the fall time of a high frequency signal input to the integrated circuit may fall within specified ranges, and thereby they can reduce development man-hours.

The reason is that the control circuit according to this example embodiment adjusts the resistance value so that the rise time and the fall time of a high frequency signal input to the integrated circuit may fall within the specified ranges and that the circuit outputs an ALM signal when it fails to adjust the resistance value. Hardware engineers merely have to adjust, among integrated circuits mounted on an electronic board, the resistance value only for an integrated circuit connected to the control circuit that outputs the ALM signal. Therefore, the hardware engineers do not necessarily have to adjust the resistance value for all the integrated circuits mounted on the electronic board, and they can reduce effort to adjust the resistance value, and thereby they can reduce development man-hours.

While the invention has been particularly shown and described with reference to example embodiments thereof, the invention is not limited to these embodiments. It will be understood by those of ordinary skill in the art that various changes in form and details may be made therein without departing from the spirit and scope of the present invention as defined by the claims.

This application is based upon and claims the benefit of priority from Japanese Patent Application No. 2014-182836 filed on September 9, 2014, the disclosure of which is incorporated herein in its entirety by reference.

The whole or part of the example embodiments disclosed above can be described as, but not limited to, the following supplementary notes.

(Supplementary Note 1)

A control circuit comprising:

a conductive wire for transmitting an input electric signal to a connected integrated circuit;
a resistor circuit connected to the conductive wire and grounded, the resistance value of which is variable;
a measuring means for measuring one of or both of a rise time and a fall time, the rise time being taken for a voltage value of the electric signal transmitted through the conductive wire across the resistor circuit and the integrated circuit to rise from a predetermined first voltage value up to a predetermined second voltage value larger than the first voltage value, and the fall time being taken for the voltage value of the signal to fall from a predetermined third voltage value down to a predetermined fourth voltage value smaller than the third voltage value; and
a control means for changing a resistance value of the resistor circuit to a smaller value by a certain amount when at least one of the times measured by the measuring means is shorter than a minimum time of a predetermined time range, and to a larger value by a certain amount when at least one of the times measured by the measuring means is longer than a maximum time of the predetermined time range,
wherein the control means outputs a predetermined signal in response to changing the resistance value a predetermined number of times.

(Supplementary Note 2)

The control circuit according to Supplementary Note 1,
wherein the first voltage value is a voltage value corresponding to a first percentage of a predetermined operating voltage value for operating the integrated circuit,
wherein the second voltage value is a voltage value corresponding to a second percentage of the operating voltage value,

wherein the second percentage is larger than the first percentage,
wherein the third voltage value is a voltage value corresponding to a third percentage of the operating voltage value,
wherein the fourth voltage value is a voltage value corresponding to a fourth percentage of the operating voltage value, and
wherein the fourth percentage is smaller than the third percentage.

(Supplementary Note 3)

The control circuit according to Supplementary Note 1 or 2,
wherein the measuring means measures both of the rise time and the fall time, and
wherein the control means changes the resistance value of the resistor circuit to a smaller value by a certain amount when the rise time is shorter than a minimum time of a predetermined time range of a first kind related to the rise time or when the fall time is shorter than a minimum time of a predetermined time range of a second kind related to the fall time, and to a larger value by a certain amount when the rise time is longer than a maximum time of the time range of the first kind or when the fall time is longer than a maximum time of the time range of the second kind.

(Supplementary Note 4)

The control circuit according to any one of Supplementary Notes 1 to 3,
wherein the resistor circuit comprises a plurality of resistors, a switch of a first kind connecting a first end of the first resistor and a first end of the second resistor, a switch of the first kind connecting a second end of the first resistor and a second end of the second resistor, and a switch of a second kind connecting the second end of the first resistor and the first end of the second resistor, and
wherein the control means changes the resistance value of the resistor circuit to a smaller value by a certain amount by turning on the switch of the first kind, and to a larger value by a certain amount by turning on the switch of the second kind.

(Supplementary Note 5)

The control circuit according to any one of Supplementary Notes 1 to 4,
wherein the predetermined signal is a signal indicating that the resistance value failed to be adjusted.

(Supplementary Note 6)

The control circuit according to any one of Supplementary Notes 1 to 5, comprising a voltage detecting means for measuring a voltage value of the electric signal transmitted through the conductive wire across the resistor circuit and the integrated circuit,
wherein the measuring means measures one of or both of the rise time and the fall time, the rise time being taken for a measured voltage value measured by the voltage detection means to rise from the first voltage value up to the second voltage value, and the fall time being taken for the measured voltage value to fall from the third voltage value down to the fourth voltage value.

(Supplementary Note 7)

A control method comprising:

measuring one of or both of a rise time and a fall time, the rise time being taken for a voltage value of an electric signal to rise from a predetermined first voltage value up to a predetermined second voltage value larger than the first voltage value, the fall time being taken for the voltage value of the electric signal to fall from a predetermined third voltage value down to a fourth voltage value smaller than the third voltage value, and the voltage value of the electric signal being transmitted through a conductive wire across an integrated circuit and a resistor circuit which is connected to the conductive wire connected to the integrated circuit and is grounded, the resistance value of which resistor circuit is a variable resistance value;
changing the resistance value of the resistor circuit to a smaller value by a certain amount when at least one of the measured times is shorter than a minimum time of a predetermined time range, and to a larger value by the certain amount when at least one of the measured times is longer than a maximum time of the predetermined time range; and
outputting a predetermined signal in response to changing the resistance value the predetermined number of times.

(Supplementary Note 8)

The control method according to Supplementary Note 7,
wherein the first voltage value is a voltage value corresponding to a first percentage of a predetermined operating voltage value for operating the integrated circuit,
wherein the second voltage value is a voltage value corresponding to a second percentage of the operating voltage value,
wherein the second percentage is larger than the first percentage,
wherein the third voltage value is a voltage value corresponding to a third percentage of the operating voltage value,
wherein the fourth voltage value is a voltage value corresponding to a fourth percentage of the operating voltage value, and
wherein the fourth percentage is smaller than the third percentage.

(Supplementary Note 9)

The control method according to Supplementary Note 7 or 8, comprising:

measuring both of the rise time and the fall time; and
changing the resistance value of the resistor circuit to a smaller value by a certain amount when the rise time is shorter than a minimum time of a predetermined time range of a first kind related to the rise time or when the fall time is shorter than a minimum time of a predetermined time range of a second kind related to the fall time, and to a larger value by a certain amount when the rise time is longer than a maximum time of the time range of the first kind or when the fall time is longer than a maximum time of the time range of the second kind.

(Supplementary Note 10)

The control method according to any one of Supplementary Notes 7 to 9, comprising:

changing the resistance value of the resistor circuit to a smaller value by a certain amount by connecting a first end of a first resistor and a first end of a second resistor, the resistors being provided in the resistor circuit, and furthermore connecting a second end of the first resistor and a second end of the second resistor, and to a larger value by a certain amount by connecting the second end of the first resistor and the first end of the second resistor.

(Supplementary Note 11)

The control method according to any one of Supplementary Notes 7 to 10, wherein the predetermined signal is a signal indicating that the resistance value failed to be adjusted.

(Supplementary Note 12)

The control circuit according to any one of Supplementary Notes 4 to 5, wherein the switch includes an FET (Field Effect Transistor).

[Reference signs List]

10 signal-receiving terminal
11 pull-down resistor circuit
12 voltage detection circuit
13, 203 control unit
14 ALM terminal
15 LSI (Large Scale Integration) main body
16 IC (Integrated Circuit)
20 control circuit
21 integrated circuit
100_1 1 to 100_n resistor
101_1 to 101_(n - 1), 102_1 to 102_(n - 1), 103_1 to 103_(n - 1) FET (Field Effect Transistor)
200 conductive wire
201 resistor circuit

202 measurement unit

**Claims**

1. A control circuit comprising:

   a conductive wire for transmitting an input electric signal to a connected integrated circuit;
   a resistor circuit connected to the conductive wire and grounded, the resistance value of which is variable;
   a measuring means for measuring one of or both of a rise time and a fall time, the rise time being taken for a voltage value of the electric signal transmitted through the conductive wire across the resistor circuit and the integrated circuit to rise from a predetermined first voltage value up to a predetermined second voltage value larger than the first voltage value, and the fall time being taken for the voltage value of the signal to fall from a predetermined third voltage value down to a predetermined fourth voltage value smaller than the third voltage value; and
   a control means for changing a resistance value of the resistor circuit to a smaller value by a certain amount when at least one of the times measured by the measuring means is shorter than a minimum time of a predetermined time range, and to a larger value by a certain amount when at least one of the times measured by the measuring means is longer than a maximum time of the predetermined time range,
   wherein the control means outputs a predetermined signal in response to changing the resistance value a predetermined number of times.

2. The control circuit according to claim 1,
   wherein the first voltage value is a voltage value corresponding to a first percentage of a predetermined operating voltage value for operating the integrated circuit,
   wherein the second voltage value is a voltage value corresponding to a second percentage of the operating voltage value,
   wherein the second percentage is larger than the first percentage,
   wherein the third voltage value is a voltage value corresponding to a third percentage of the operating voltage value,
   wherein the fourth voltage value is a voltage value corresponding to a fourth percentage of the operating voltage value, and
   wherein the fourth percentage is smaller than the third percentage.

3. The control circuit according to claim 1 or 2,
   wherein the measuring means measures both of the rise time and the fall time, and
   wherein the control means changes the resistance value of the resistor circuit to a smaller value by a certain amount when the rise time is shorter than a minimum time of a predetermined time range of a first kind related to the rise time or when the fall time is shorter than a minimum time of a predetermined time range of a second kind related to the fall time, and to a larger value by a certain amount when the rise time is longer than a maximum time of the time range of the first kind or when the fall time is longer than a maximum time of the time range of the second kind.

4. The control circuit according to any one of claims 1 to 3,
   wherein the resistor circuit comprises a plurality of resistors, a switch of a first kind connecting a first end of the first resistor and a first end of the second resistor, a switch of the first kind connecting a second end of the first resistor and a second end of the second resistor, and a switch of a second kind connecting the second end of the first resistor and the first end of the second resistor, and
   wherein the control means changes the resistance value of the resistor circuit to a smaller value by a certain amount by turning on the switch of the first kind, and to a larger value by a certain amount by turning on the switch of the second kind.

5. The control circuit according to any one of claims 1 to 4,
   wherein the predetermined signal is a signal indicating that the resistance value failed to be adjusted.

6. The control circuit according to any one of claims 1 to 5, comprising a voltage detecting means for measuring a voltage value of the electric signal transmitted through the conductive wire across the resistor circuit and the integrated circuit,
   wherein the measuring means measures one of or both of the rise time and the fall time, the rise time being taken for a measured voltage value measured by the voltage detection means to rise from the first voltage value up to the second voltage value, and the fall time being taken for the measured voltage value to fall from the third voltage value down to the fourth voltage value.

7. A control method comprising:

measuring one of or both of a rise time and a fall time, the rise time being taken for a voltage value of an electric signal to rise from a predetermined first voltage value up to a predetermined second voltage value larger than the first voltage value, the fall time being taken for the voltage value of the electric signal to fall from a predetermined third voltage value down to a fourth voltage value smaller than the third voltage value, and the voltage value of the electric signal being transmitted through a conductive wire across an integrated circuit and a resistor circuit which is connected to the conductive wire connected to the integrated circuit and is grounded, the resistance value of which resistor circuit is a variable resistance value;
changing the resistance value of the resistor circuit to a smaller value by a certain amount when at least one of the measured times is shorter than a minimum time of a predetermined time range, and to a larger value by the certain amount when at least one of the measured times is longer than a maximum time of the predetermined time range; and
outputting a predetermined signal in response to changing the resistance value the predetermined number of times.

8. The control method according to claim 7,
wherein the first voltage value is a voltage value corresponding to a first percentage of a predetermined operating voltage value for operating the integrated circuit,
wherein the second voltage value is a voltage value corresponding to a second percentage of the operating voltage value,
wherein the second percentage is larger than the first percentage,
wherein the third voltage value is a voltage value corresponding to a third percentage of the operating voltage value,
wherein the fourth voltage value is a voltage value corresponding to a fourth percentage of the operating voltage value, and
wherein the fourth percentage is smaller than the third percentage.

9. The control method according to claim 7 or 8, comprising:

measuring both of the rise time and the fall time; and
changing the resistance value of the resistor circuit to a smaller value by a certain amount when the rise time is shorter than a minimum time of a predetermined time range of a first kind related to the rise time or when the fall time is shorter than a minimum time of a predetermined time range of a second kind related to the fall time, and to a larger value by a certain amount when the rise time is longer than a maximum time of the time range of the first kind or when the fall time is longer than a maximum time of the time range of the second kind.

10. The control method according to any one of claims 7 to 9, comprising:

changing the resistance value of the resistor circuit to a smaller value by a certain amount by connecting a first end of a first resistor and a first end of a second resistor, the resistors being provided in the resistor circuit, and furthermore connecting a second end of the first resistor and a second end of the second resistor, and to a larger value by a certain amount by connecting the second end of the first resistor and the first end of the second resistor.

# Fig. 1

CONFIGURATION EXAMPLE OF LSI INCLUDING CONTROL CIRCUIT IN
FIRST EXAMPLE EMBODIMENT

# Fig. 2

TURN ON 101_1 AND 103_1

TURN OFF 102_1

UPPER DIAGRAM

TURN OFF 101_1 AND 103_1

TURN ON 102_1

100_2 (RESISTOR)

100_1 (RESISTOR)

LOWER DIAGRAM

DIAGRAM FOR EXPLAINING FUNCTION OF PULL-DOWN RESISTOR CIRCUIT 11

EP 3 193 362 A1

## Fig. 3

VOLTAGE VALUE VIH (2.64V)
(80% OF OPERATING
VOLTAGE VALUE)

VOLTAGE VALUE VIL (0.66V)
(20% OF OPERATING
VOLTAGE VALUE)

RISE TIME                    FALL TIME

OPERATING VOLTAGE VALUE = 3.3V

CHART FOR EXPLAINING RISE TIME AND FALL TIME TREATED BY CONTROL CIRCUIT IN
FIRST EXAMPLE EMBODIMENT OF PRESENT INVENTION

EP 3 193 362 A1

## Fig. 4

INPUT SIGNAL →

REFLECTED WAVE ←

CIRCUIT A

Z0

SOURCE OF
HIGH
FREQUENCY
SIGNAL

Z0:IMPEDANCE BETWEEN
SIGNAL SOURCE AND
CIRCUIT A

Rt:RESISTANCE VALUE

REFLECTION COEFFICIENT
=(Rt-Z0)/(Rt+Z0)

DIAGRAM FOR EXPLAINING REFLECTION COEFFICIENT

EP 3 193 362 A1

## Fig. 5A

```
                    ( START )
                        │
        ┌───────────────────────────────┐
        │  SET OPERATING CONDITION      │── S1
        │            (13)               │
        └───────────────────────────────┘
                        │←──────────── (D)
        ┌───────────────────────────────┐
        │    SET RESISTANCE VALUE       │── S2
        │         (101〜103)            │
        └───────────────────────────────┘
     (C)──────────────────►│
        ┌───────────────────────────────┐
        │    RECEIVE RISE SIGNAL        │── S3
        │            (10)               │
        └───────────────────────────────┘
                        │
        ┌───────────────────────────────┐
        │      DETECT VOLTAGE           │── S4
        │            (12)               │
        └───────────────────────────────┘
                        │
        ┌───────────────────────────────┐
        │     START TIMER WHEN          │── S5
        │       DETECTING VIL           │
        │            (13)               │
        └───────────────────────────────┘
                        │
        ┌───────────────────────────────┐
        │      STOP TIMER WHEN          │── S6
        │       DETECTING VIH           │
        │            (13)               │
        └───────────────────────────────┘
                        │
                      ◇ S7
        TIMER VALUE (RISE TIME)
        IS WITHIN SPECIFIED RANGE?        ── YES ──► (A)
        WITHIN SPECIFIED RANGE → Yes
        OUT OF SPECIFIED RANGE → No
                  (13)
                   │ NO
                      ◇ S8
        MAXIMUM NUMBER OF TRIALS?          ── YES ──► (B)
                   │ NO
                      ◇ S9
            RISE TIME IS
        SHORTER THAN TIME FOR             ── YES ──┐
          SPECIFIED RANGE?
          SHORTER → Yes
          LONGER → No
                   │ NO              S10                   S11
   ┌───────────────────────────┐   ┌───────────────────────────┐
   │ SET LARGER RESISTANCE     │   │ SET SMALLER RESISTANCE    │
   │       VALUE               │   │       VALUE               │
   │  (101_n、103_n)ON         │   │  (101_n、103_n)OFF        │
   │  (102_n)OFF               │   │  (102_n)ON                │
   └───────────────────────────┘   └───────────────────────────┘
```

OPERATION EXAMPLE OF CONTROL CIRCUIT IN
FIRST EXAMPLE EMBODIMENT

Fig. 5B

```
                    (A)                                              (D)
                     │                                                │
          ┌──────────────────────┐                    ┌──────────────────────┐
          │  RECEIVE FALL SIGNAL  │─S23          S34─│       CHANGE          │
          │        (100)          │                   │      OPERATING        │
          └──────────────────────┘                   │     CONDITION         │
                     │                                 │        (13)           │
          ┌──────────────────────┐                    └──────────────────────┘
          │    DETECT VOLTAGE     │─S24                           ▲
          │        (12)           │                               │
          └──────────────────────┘
                     │
          ┌──────────────────────┐
          │   START TIMER WHEN    │─S25
          │    DETECTING VIH      │
          │        (13)           │
          └──────────────────────┘
                     │
          ┌──────────────────────┐
          │   STOP TIMER WHEN     │─S26
          │    DETECTING VIL      │
          │        (13)           │
          └──────────────────────┘
                     │
                    S27
             ╱TIMER VALUE ╲                                     S33
           ╱ (FALL TIME) IS WITHIN ╲                      ╱         ╲        YES
          ╱  SPECIFIED RANGE?        ╲──── YES ────────╲  RETURN?   ╲────────
          ╲ WITHIN SPECIFIED RANGE → Yes ╱                ╲         ╱
           ╲OUT OF SPECIFIED RANGE → No ╱                   ╲     ╱
             ╲      (13)      ╱                                NO
                  │ NO
                 S28
           ╱ MAXIMUM NUMBER ╲──── YES ──┐
           ╲  OF TRIALS?     ╱          │
                  │ NO              (B)──▶   S32
                 S29                  ┌─────────────────┐
           ╱  FALL TIME IS  ╲         │   INFORM ALM    │
          ╱ SHORTER THAN TIME╲  YES   │    TERMINAL     │
          ╲FOR SPECIFIED RANGE?╱──────│      (14)       │
          ╲ SHORTER → Yes    ╱        └─────────────────┘
           ╲ LONGER → No    ╱
                  │ NO  S30                        S31
          ┌──────────────────┐        ┌──────────────────┐
          │   SET LARGER     │        │   SET SMALLER    │
          │ RESISTANCE VALUE │        │ RESISTANCE VALUE │
          │ (101_n、103_n)ON │        │ (101_n、103_n)OFF│
          │   (102_n)OFF     │        │   (102_n)ON      │
          └──────────────────┘        └──────────────────┘
                  │                            │
                 (C)                          (C)              END
```

OPERATION EXAMPLE OF CONTROL CIRCUIT IN
FIRST EXAMPLE EMBODIMENT

# Fig. 6

CONFIGURATION EXAMPLE OF CONTROL CIRCUIT IN
SECOND EXAMPLE EMBODIMENT

EP 3 193 362 A1

## INTERNATIONAL SEARCH REPORT

| | International application No. |
|---|---|
| | PCT/JP2015/004433 |

A. CLASSIFICATION OF SUBJECT MATTER
*H01L21/822*(2006.01)i, *G01R31/28*(2006.01)i, *H01L21/82*(2006.01)i, *H01L27/04* (2006.01)i

According to International Patent Classification (IPC) or to both national classification and IPC

B. FIELDS SEARCHED

Minimum documentation searched (classification system followed by classification symbols)
H01L21/822, G01R31/28, H01L21/82, H01L27/04

Documentation searched other than minimum documentation to the extent that such documents are included in the fields searched
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-364276 A (Hewlett-Packard Development Co., L.P.), 24 December 2004 (24.12.2004), entire text; all drawings & US 2004/0239390 A1 | 1-10 |
| A | JP 2011-114488 A (Panasonic Electric Works Co., Ltd.), 09 June 2011 (09.06.2011), entire text; all drawings (Family: none) | 1-10 |
| A | JP 1-121779 A (Hitachi Electronics Engineering Co., Ltd.), 15 May 1989 (15.05.1989), entire text; all drawings (Family: none) | 1-10 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search 06 October 2015 (06.10.15) | Date of mailing of the international search report 13 October 2015 (13.10.15) |
|---|---|
| Name and mailing address of the ISA/ Japan Patent Office 3-4-3,Kasumigaseki,Chiyoda-ku, Tokyo 100-8915,Japan | Authorized officer |
| | Telephone No. |

Form PCT/ISA/210 (second sheet) (July 2009)

**INTERNATIONAL SEARCH REPORT**

International application No.

PCT/JP2015/004433

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-140328 A (Seiko Epson Corp.), 01 June 2006 (01.06.2006), entire text; all drawings (Family: none) | 1-10 |
| A | JP 2006-259904 A (Toshiba Corp.), 28 September 2006 (28.09.2006), entire text; all drawings (Family: none) | 1-10 |
| A | WO 2010/067502 A1 (Panasonic Corp.), 17 June 2010 (17.06.2010), entire text; all drawings & JP 2010-140279 A & US 2011/0210453 A1 | 1-10 |

Form PCT/ISA/210 (continuation of second sheet) (July 2009)

**EP 3 193 362 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011081733 A
- JP 2009152865 A
- JP 2008182516 A
- JP 2014182836 A